# EUROPÄISCHE PATENTSCHRIFT

(11) **EP 2 416 386 B1**
(45) Veröffentlichungstag und Bekanntmachung des Hinweises auf die Patenterteilung: **15.07.2020**
(21) Anmeldenummer: 11176530.1
(22) Anmeldetag: 04.08.2011
(51) Int. Cl.: H01L 31/18, H01L 31/068, H01L 31/0216, H01L 21/225, H01L 21/56, H01L 31/0236, H01L 21/268

(54) **Herstellungsverfahren einer Halbleitervorrichtung mit einer Passivierschicht und entsprechende Halbleitervorrichtung**
Method of making a semiconductor device having a passivation layer and corresponding semiconductor device
Méthode de fabrication d'un dispositif semi-conducteur ayant une couche de passivation et dispositif semi-conducteur correspondant

(30) Priorität: 06.08.2010 DE 102010036893
(43) Veröffentlichungstag der Anmeldung: 08.02.2012
(73) Patentinhaber: Hanwha Q.CELLS GmbH, 06766 Bitterfeld-Wolfen (DE)
(72) Erfinder: Engelhart, Peter, 04157 Leipzig (DE); Scherff, Maximilian, 44369 Dortmund (DE); Bordihn, Stefan, 04109 Leipzig (DE); Klöter, Bernhard, 04158 Leipzig (DE)
(74) Vertreter: Bakhtyari, Arash

(56) Entgegenhaltungen:
- WO-A1-00/01019
- US-B1- 7 517 709
- SAINT-CAST P ET AL: "High-Efficiency c-Si Solar Cells Passivated With ALD and PECVD Aluminum Oxide", IEEE ELECTRON DEVICE LETTERS, Bd. 31, Nr. 7, Juli 2010 (2010-07), Seiten 695-697, XP011310183, IEEE, New York, NY, USA ISSN: 0741-3106
- GLUNZ S W ET AL: "n-type silicon - enabling efficiencies > 20% in industrial production", 35TH IEEE PHOTOVOLTAIC SPECIALISTS CONFERENCE (PVSC), 20-25 JUNE 2010, HONOLULU, HI, USA, 20. Juni 2010 (2010-06-20), - 25. Juni 2010 (2010-06-25), Seiten 50-56, XP031784010, IEEE, New York, USA ISBN: 978-1-4244-5890-5

## Beschreibung

Die Erfindung betrifft ein Herstellungsverfahren einer Halbleitervorrichtung. Insbesondere betrifft die Erfindung ein Herstellungsverfahren einer Solarzelle.

Bei der Halbleitervorrichtungsherstellung und insbesondere bei der Herstellung von Solarzellen werden auf einem Halbleitersubstrat mittels Dotierung oder Abscheidung dotierte Bereiche erzeugt, welche mit dem Substratmaterial je nach Anwendungszweck einen pn-Übergang, einen pp⁺-Übergang oder einen nn⁺-Übergang bilden. Bei Photovoltaikelementen wie beispielsweise Solarzellen kann ein pn-Übergang zur Trennung von bei Lichteinstrahlung erzeugten freien Ladungsträgern dienen. Demgegenüber handelt es sich bei pp⁺-Übergängen oder nn⁺-Übergängen um sogenannte High-Low Junctions, welche unterhalb eines Metallkontaktes angeordnet eine verbesserte Kontaktierung der Halbleitervorrichtung erlauben, und andererseits auch zu einer reduzierten Rekombinationsaktivität und somit zu einer höheren Effizienz der Halbleitervorrichtung führen können.
Derartige Übergänge können auf der Vorder- und / oder Rückseite der Halbleitervorrichtung erzeugt werden. Beispielsweise können sie mittels lokal dotierten Bereichen gebildet sein, insbesondere mittels lokal hochdotierten Bereichen, wie dies zum Beispiel bei den sogenannten selektiven Emittern der Fall ist. Solche lokale Dotierungen werden üblicherweise mithilfe von laserinduzierten Diffusionsvorgängen eingeleitet. Ein Beispiel hierfür bildet unter anderem das Einlegieren von Aluminium aus einer Metallschicht in ein darunterliegendes Halbleitersubstrat mittels punktueller Laserbestrahlung. Dieser Einlegierungsprozess läuft auch bei der laserinduzierten Kontaktierung einer Aluminiumfolie mit einem Halbleitersubstrat ab, dessen Ergebnis als Laser-Fired Contact (LFC) bezeichnet wird.

Weitere bekannte Verfahren zur Erzeugung lokaler Dotierungen ist die lokale Diffusion aus einer lokal auf das Halbleitersubstrat aufgebrachten Diffusionsquelle oder die lokale Diffusion durch eine Diffusionsmaske hindurch. Derartige Verfahren sind jedoch in der Regel aufwendig und teuer, da sie entweder teure Diffusionsquellen benötigen oder weil die Maskierung aufwendig ist. Zudem sind die Prozessfenster für solche Verfahren häufig klein. Darüber hinaus besteht häufig das Problem, dass nach dem Dotierschritt eine weitere Funktionsschicht auf dem dotierten Halbleitersubstrat aufgebracht werden muss, beispielsweise eine Passivierschicht oder eine Reflexions- oder Antireflexionsschicht. Um die dotierten Bereiche danach kontaktieren zu können, müssen durch die Funktionsschicht Kontaktöffnungen erzeugt werden, welche zu den dotierten Bereichen exakt ausgerichtet sind.

Gemäß einem aus WO0001019 bekannten Verfahren wird ein Substrat mit einer Dielektrikschicht beschichtet, die als Dotierquelle dient. Hierbei ist das Material der Dotierquelle so zu wählen, dass sie anschließend zur Oberflächenpassivierung dient. Nachdem auf der Halbleiteroberfläche mittels Eintreiben von Dotanden aus der Dielektrikschicht eine Dotierschicht gebildet ist, wird mittels Lasereinstrahlung eine stärker dotierte Lokalregion geschaffen, welche zur Kontaktierung dient.

In der US7,517,709B1 wird ein Verfahren beschrieben, bei dem ein Halbleitersubstrat mit einer Passivierschicht und einer Absorptionsschicht bereitgestellt wird. Dabei ist die Passivierschicht aus Siliziumdioxid gebildet und enthält Arsen und Bor als Dotiermittel. Mittels Laserbehandlung werden Dotierbereiche erzeugt.

In der Druckschrift Saint-Cast et al., "High Efficiency c-Si Solar Cell Passivated With ALD and PECVD Aluminium Oxide", IEEE Electron Device Letters, Vol. 31, No. 7 (Juli 2010), Seiten 695-697, werden unterschiedliche Passivierschichten miteinander verglichen. Es handelt sich hierbei einerseits um Aluminiumoxid-Schichten, welche mittels unterschiedlicher Abscheideverfahren erzeugt wurden, und andererseits um eine thermisch erzeugte Siliziumdioxid-Schicht. Mit Aluminiumoxid dotierte Wafersolarzellen werden in der Druckschrift Gluns et al.:"n-Type Silicon-enabling Efficiencies > 20% In Industrial Production", 35th IEEE Photovoltaic Specialists Conference, 20-25 Juli 2010, Seiten 50-56, offenbart.
Es ist Aufgabe der Erfindung, ein Herstellungsverfahren einer Halbleitervorrichtung und eine Halbleitervorrichtung bereitzustellen, bei denen dotierte Halbleiterbereiche auf effiziente und kostengünstige Weise erzeugt werden, insbesondere im Hinblick auf eine möglichst exakte Ausrichtung beziehungsweise Justierung von Funktionsschichtöffnungen mit diesen dotierten Halbleiterbereichen.
Die Aufgabe wird gemäß der Erfindung durch ein Herstellungsverfahren einer Halbleitervorrichtung mit den Merkmalen des Anspruchs 1 gelöst. Vorteilhafte Weiterbildungen der Erfindung sind in den Unteransprüchen 2-10 aufgeführt.
Die Erfindung beruht auf der Erkenntnis, dass eine auf einer Halbleiteroberfläche des Halbleitersubstrats während der Herstellung der Halbleitervorrichtung aufgebrachte Funktionsschicht zugleich als Lieferant für den Dotierstoff fungiert, der für die Dotierung des Halbleitersubstrats unterhalb der Funktionsschicht dient, um so einen Dotierbereich zu erzeugen. Die aufgebrachte Funktionsschicht passiviert zum Ende des Herstellungsverfahrens und darüber hinaus als Passivierschicht die Halbleiteroberfläche des Halbleitersubstrats. Zum Dotieren des Halbleitersubstrats wird der Dotierstoff aus der Funktionsschicht an vorgesehenen Bereichen der Halbleiteroberfläche in das Halbleitersubstrat eingetrieben.

Die Passivierwirkung behält die als Passivierschicht wirkende Funktionsschicht im Wesentlichen nur an den an der Halbleiteroberfläche angrenzenden Bereichen, welche nicht die Dotierbereiche sind. Mit anderen Worten, werden an einem Teil der Halbleiteroberfläche Dotierstoffes aus der darüber liegenden Funktionsschicht in das Halbleitersubstrat getrieben, während an dem übrigen Teil der Halbleiteroberfläche die Funktionsschicht später als Passivierschicht wirkt. Die Passivierwirkung kann also an den Dotierbereichen aufgrund des Vorgangs des Eintreibens des Dotierstoffes vermindert oder sogar zerstört werden. Es ist sogar möglich, dass die Funktionsschicht an den zugehörigen Stellen aufgrund des Eintreibvorgangs teilweise oder vollständig zerstört wird.

Die durch die Funktionsschicht gebildete Passivierschicht passiviert die Halbleiteroberfläche mittels einer chemischen und / oder mittels einer Feldeffektpassivierung. Während beim ersteren Mechanismus Rekombinationszentren, wie beispielsweise freie Bindungsstellen (sogenannten Dangling Bonds), aufgrund der Passivierschicht entfernt werden, wird die Rekombinationsaktivität bei der Feldeffektpassivierung dadurch vermindert, dass freie Ladungsträger von der Halbleiteroberfläche weggedrückt werden.

Bei einer bevorzugten Ausführungsform ist vorgesehen, dass das Eintreiben des Dotierstoffes aus der Funktionsschicht in das Halbleitersubstrat mittels eines Energieeintrags erfolgt. Der Energieeintrag erfolgt vorzugsweise lokalisiert, und zwar nur an den Stellen auf der Funktionsschicht, unterhalb derer Dotierbereiche erzeugt werden sollen. Bei einem geeigneten Energieeintrag kann das Halbleitersubstrat an der Halbleiteroberfläche lokal aufgeschmolzen werden, wodurch die Diffusion des Dotierstoffes in das geschmolzene Halbleitersubstrat erfolgt.

Zweckmäßigerweise erfolgt das Eintreiben des Dotierstoffes aus der Funktionsschicht in das Halbleitersubstrat mittels einer Laserquelle. Hierbei können Laserquellen mit Spotgrößen oder Durchmessern von zwischen etwa 10 nm bis 100 nm, vorzugsweise zwischen etwa 10 nm und 50 nm eingesetzt werden. Die eingesetzten Laserstrahlen können ferner eine Fluenz oder Energiedichte von bis zu 0,1 bis 10 J/cm² aufweisen, vorzugsweise von bis zu 0,2 bis 2 J/cm², eher bevorzugt bis zu einem Wert zwischen etwa 0,5 und 1,5 J/cm². Die Wellenlängen der hierzu verwendeten Laser liegen bevorzugt zwischen etwa 300 nm und 1200 nm, eher bevorzugt zwischen etwa 300 nm und 600 nm. Vorteilhafterweise, insbesondere aus Kostengründen, können Wellenlängenbereiche im sichtbaren Bereich oder zwischen etwa 400 nm und 600 nm eingesetzt werden. Die in diesem Absatz aufgeführten drei Laserparameter können unabhängig voneinander gewählt werden.

Bevorzugterweise ist vorgesehen, dass mittels des Energieeintrags eine Öffnung in der Funktionsschicht gebildet wird, welche bei Fertigstellung der Halbleitervorrichtung als Passivierschichtöffnung in der Passivierschicht vorliegt. Ein Vorteil liegt hierbei darin, dass die so gebildeten Passivierschichtöffnungen an den mittels des Energieeintrags erzeugten Dotierbereichen ausgerichtet oder justiert sind. Es handelt sich hierbei also um eine Selbstjustierung.

Bei einer zweckmäßigen Ausführungsform ist vorgesehen, dass auf der Funktionsschicht eine Kontaktschicht aufgebracht wird, welche das Halbleitersubstrat an dem Dotierbereich durch die Öffnung hindurch elektrisch kontaktiert. Bei der Kontaktschicht kann es sich hierbei um eine Metallschicht handeln, welche mittels eines Abscheide- oder eines anderen geeigneten Verfahrens auf die Funktionsschicht aufgebracht wird und hierbei in die Öffnung eindringt. Gleichzeitig mit der Erzeugung des Dotierbereiches wird also eine Kontaktöffnung gebildet.

In einer vorteilhaften Ausgestaltung ist vorgesehen, dass der Dotierstoff vor dem Schritt des Eintreibens in einer Verbindung eines Funktionsschichtmaterials vorliegt, aus welcher die Funktionsschicht gebildet ist. Vorzugsweise wird diese Verbindung mittels des Energieeintrags aufgespaltet, welcher anschließend das Eintreiben des abgespaltenen Dotierstoffes bewirkt.

Gemäß einer Ausführungsform ist die Funktionsschicht aus Aluminiumoxid (AlOₓ) gebildet, worin der Dotierstoff Aluminium in Verbindung vorliegt. In einem aus Silizium gebildeten Halbleitersubstrat, erzeugt eine Eindiffusion von Aluminium eine p-Typ Dotierung.

Weitere vorteilhafte Funktionsschichtmaterialien sind Titanoxid (TiOₓ), Magnesiumoxid (MgOₓ) oder Zinnoxid (ZnOₓ), wobei entsprechend Titan, Magnesium oder Zinn als Dotierstoff fungiert und zwecks Herstellung des Dotierbereichs in das Halbleitersubstrat eindiffundiert beziehungsweise eingetrieben wird.
Gemäß einer bevorzugten Ausgestaltung ist vorgesehen, dass das Halbleitersubstrat an der Halbleiteroberfläche unmittelbar vor dem Bilden der Funktionsschicht im Wesentlichen die gleiche Dotierung aufweist, wie im Volumen des Halbleitersubstrats. Dies bedeutet, dass die Halbleiteroberfläche vor dem Aufbringen der Funktionsschicht undotiert ist beziehungsweise die Bulk-Dotierung des Halbleitersubstrats aufweist.
Alternativ hierzu können vor dem Bilden der Funktionsschicht an der Halbleiteroberfläche ein oder mehrere Dotierbereiche erzeugt werden, deren Dotierung mittels des Eintreibens des Dotierstoffes aus der Funktionsschicht in das Halbleitersubstrat lokal verstärkt und / oder invertiert werden. Anders ausgedrückt, werden vor dem Aufbringen der Funktionsschicht im oder auf dem Halbleitersubstrat Dotierbereiche erzeugt, beispielsweise mittels Dotierung des Halbleitersubstrats an der Halbleiteroberfläche und / oder mittels Abscheidung der Dotierbereiche auf die Halbleiteroberfläche. Bei dem mittels Dotierung oder mittels Abscheiden erzeugten Dotierbereich kann es sich um eine Dotierschicht handeln, welche vorzugsweise die gesamte Halbleiteroberfläche bedeckt. Mittels des Eintreibens erfolgt dann eine Eindiffusion des Dotierstoffes in diesen Dotierbereich beziehungsweise in diese Dotierbereiche, wodurch eine lokal Verstärkung und / oder eine Inversion der Dotierbereiche erreicht wird.

In einer zweckmäßigen Weiterbildung ist vorgesehen, dass das Halbleitersubstrat im Volumen ein p-Typ oder ein n-Typ Halbleiter ist. Beispielsweise kann es sich bei dem Halbleitersubstrat um einen vordotierten Halbleiterwafer handeln. Dass das Halbleitersubstrat im Volumen ein p-Typ oder ein n-Typ Halbleiter ist bedeutet, dass eine dünne Schicht entlang der Halbleiteroberfläche eine gegenüber dem Volumen verstärkte oder entgegengesetzte Dotierung aufweisen kann. In diesem Fall kann beispielsweise ein pn-Übergang oder ein pp⁺-Übergang oder nn⁺-Übergang gebildet sein, bevor die Funktionsschicht aufgebracht wird.

Bei dem hierin beschriebenen Herstellungsverfahren handelt es sich vorzugsweise um die Herstellung einer Halbleitersolarzelle aus dem Halbleitersubstrat. Insbesondere für die Herstellung von sogenannten PERC-Solarzellen (PERC - "Passivated Emitter and Rear Cell") ist dieses Verfahren gut anwendbar. Hierbei, wie auch in allen anderen Ausführungsformen, kann das Aufbringen der Funktionsschicht und das Eintreiben des Dotierstoffes aus der Funktionsschicht in das darunterliegende Halbleitersubstrat einseitig oder beidseitig des Halbleitersubstrats erfolgen, bei einer Halbleitersolarzelle also auf der Lichteinfallseite und / oder auf der dem Lichteinfall abgewandten Rückseite.

Die Erfindung wird im Folgenden anhand von Ausführungsbeispielen unter Bezugnahme auf die Figuren erläutert, welche eine Abfolge von Verfahrensschritten anhand von Zwischenprodukten veranschaulichen. Hierbei zeigen schematisch:
- Fig. 1: ein Halbleitersubstrat mit einer texturierten Oberfläche;
- Fig. 2: das Halbleitersubstrat aus der Fig. 1 mit rückseitig aufgetragener Funktionsschicht;
- Fig. 3: das Halbleitersubstrat aus der Fig. 2 nach einem Schritt des lokalen Eintreibens eines Dotierstoffes aus der Funktionsschicht in das Halbleitersubstrat; und
- Fig. 4: eine aus dem Halbleitersubstrat gemäß Fig. 3 fertig gestellte Solarzelle mit Vorder- und Rückseitenkontaktierung.

Im Folgenden wird ein Solarzellenherstellungsverfahren beschrieben. Die erläuterten Verfahrensschritte lassen sich jedoch auch entsprechend auf andere Halbleitervorrichtungen anwenden, welche eine Passivierung ihrer Oberflächen zur Effizienzsteigerung benötigen.

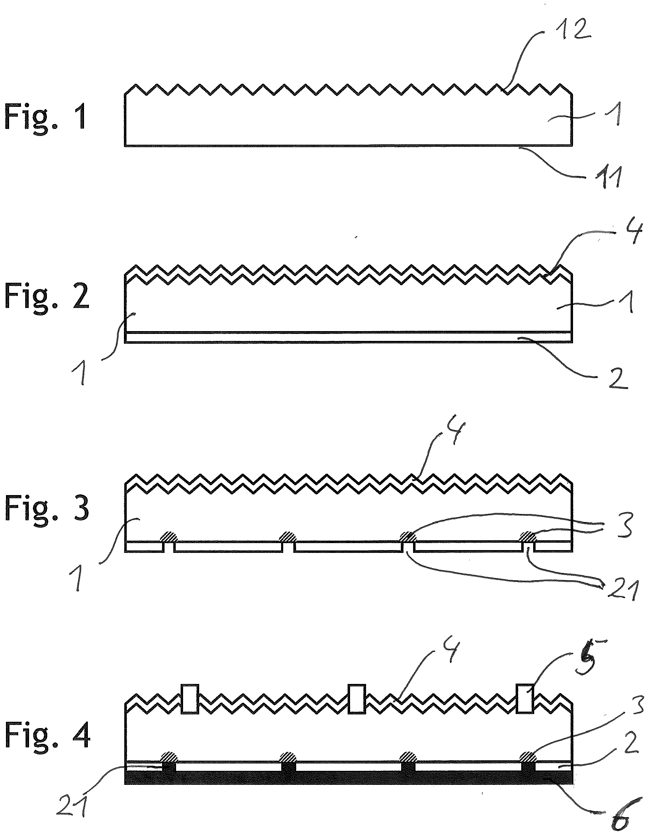

Die Fig. 1 zeigt ein Halbleitersubstrat 1 mit einer Halbleiteroberfläche 11, auf der eine Funktionsschicht aufgetragen werden soll. Die Halbleiteroberfläche 11 befindet sich auf einer Seite des Halbleitersubstrats 1, welche beim späteren Einsatz der fertigen Solarzelle dem einfallenden Licht abgewandt ist. Auf einer lichteinfallseitigen weiteren Halbleiteroberfläche 12 des Halbleitersubstrats 1 ist eine Texturierung gebildet, was durch die zickzackförmige Darstellung veranschaulicht ist. Die Texturierung wird in der Regel mittels einer Texturätzung erreicht und dient dazu, das einfallende Licht effizienter einzufangen.
Auf die Halbleiteroberfläche 11 wird in einem nachfolgenden Schritt eine Funktionsschicht 2 aufgebracht, beispielsweise mittels eines chemischen oder physikalischen Abscheideverfahrens wie CVD oder PVD (chemische oder physikalische Gasphasenabscheidung), gegebenenfalls Plasma unterstützt (PECVD, "plasma enhanced chemical vapor deposition"), oder mittels Atomlagenabscheidung (ALD). Das Resultat des Halbleitersubstrates 1 mit rückseitig aufgebrachter Funktionsschicht 2 ist in der Fig. 2 dargestellt. Darin ist auch erkennbar, dass auf der lichteinfallseitigen weiteren Halbleiteroberfläche 12 eine weitere Passivierschicht 4 aufgebracht ist. Alternativ oder zusätzlich kann die lichteinfallseitig aufgebrachte Schicht auch eine Antireflexionsschicht umfassen, um die Reflexion des einfallenden Lichts zu vermindern.

In einem weiteren Schritt wird die Halbleiteroberfläche 1 mit Laserstrahlung lokal behandelt, um an den bestrahlten Bereichen ein Dotierstoff aus der Funktionsschicht 2 in den Halbleitersubstrat 1 einzutreiben. Durch das Eindringen des Dotierstoffes in das Halbleitersubstrat 1, erfolgt an den bestrahlten Bereichen eine Dotierung des Halbleitermaterials, so dass dort Dotierbereiche 3 an der Halbleiteroberfläche 11 entstehen.

Wie in der Fig. 3 dargestellt, entstehen als Folge der Bestrahlung zudem Öffnungen 21 in der Funktionsschicht, welche zwangsläufig an den erzeugten Dotierbereichen 3 ausgerichtet sind. Die Dotierbereiche 3 können sich, abhängig von der Intensität der Laserstrahlung und gegebenenfalls von anderen Parametern, auch zum Teil unterhalb der zurückbleibenden Funktionsschicht erstrecken. Anders ausgedrückt, kann die Ausdehnung eines Dotierbereichs 3 entlang der Halbleiteroberfläche 11 größer sein, als die Ausdehnung der zugehörigen Öffnung 21.

Wie in der Fig. 4 dargestellt, wird die Solarzelle in einem nachfolgenden Kontaktierungsschritt vorder- und rückseitig kontaktiert. Während auf der lichteinfallseitigen weiteren Passivierschicht 4 eine Vorderseitenmetallisierung 5 in Form von Metallstreifen aufgebracht wird, wird die Funktionsschicht 2 beziehungsweise Passivierschicht 2 auf der Solarzellenrückseite ganzflächig mit einer Kontaktschicht 6 als Rückseitenmetallisierung bedeckt. Die Kontaktschicht 6 dringt hierbei in die Öffnungen 21 in der Passivierschicht 2 ein und stellt somit einen elektrischen Kontakt mit den Dotierbereichen 3 her.

In der hier dargestellten Ausführungsform werden mittels des laserinduzierten Eintreibens des Dotierstoffes in das Halbleitersubstrat 1 Dotierbereiche 21 gebildet, welche den Kontaktwiderstand zwischen dem Halbleitersubstrat 1 und der Rückseitenmetallisierung 6 verringern. Der für die Ladungsträgertrennung zuständige pn-Übergang hingegen, ist in den Fig. 1 bis 4 nicht dargestellt. Mittels des beschriebenen Verfahrens lassen sich jedoch auch derartige Übergänge herstellen, welche für die Trennung der durch Lichteinfall erzeugten freien Ladungsträger verantwortlich sind.

### Bezugszeichenliste:

- 1: Halbleitersubstrat
- 11: Halbleiteroberfläche
- 12: weitere Halbleiteroberfläche
- 2: Funktionsschicht (Passivierschicht)
- 21: Öffnung
- 3: Dotierbereich
- 4: weitere Passivierschicht
- 5: Vorderseitenmetallisierung
- 6: Kontaktschicht (Rückseitenmetallisierung)

## Patentansprüche

1. Herstellungsverfahren einer Halbleitervorrichtung, umfassend die folgenden Verfahrensschritte:
- Bereitstellen eines Halbleitersubstrates (1);
- Bilden einer Funktionsschicht (2) auf einer Halbleiteroberfläche (11) des Halbleitersubstrates (1); und
- Erzeugen zumindest eines Dotierbereiches (3) an der Halbleiteroberfläche (11) mittels Eintreiben eines Dotierstoffes aus der Funktionsschicht (2) in das Halbleitersubstrat (1),
wobei die Funktionsschicht (2) derart gebildet wird, dass sie bei Fertigstellung der Halbleitervorrichtung als Passivierschicht die Halbleiteroberfläche (11) passiviert, **dadurch gekennzeichnet dass** die Funktionsschicht (2) aus Aluminiumoxid (AlOₓ), Titanoxid (TiOx), Magnesiumoxid (MgOx) oder Zinkoxid (ZnOx) gebildet ist und entsprechend Aluminium, Titan, Magnesium oder Zink der Verbindung als Dotierstoff fungiert.

2. Herstellungsverfahren nach Anspruch 1, **dadurch gekennzeichnet, dass** das Eintreiben des Dotierstoffes aus der Funktionsschicht (2) in das Halbleitersubstrat (1) mittels eines Energieeintrags erfolgt.

3. Herstellungsverfahren nach Anspruch 2, **dadurch gekennzeichnet, dass** das Eintreiben des Dotierstoffes aus der Funktionsschicht (2) in das Halbleitersubstrat (1) mittels eines lokalisierten Energieeintrags erfolgt.

4. Herstellungsverfahren nach Anspruch 3, **dadurch gekennzeichnet, dass** der lokalisierte Energieeintrag mittels einer Laserquelle erfolgt.

5. Herstellungsverfahren nach einem der Ansprüche 2 bis 4, **dadurch gekennzeichnet, dass** mittels des Energieeintrags eine Öffnung (21) in der Funktionsschicht (2) gebildet wird, welche bei Fertigstellung der Halbleitervorrichtung als Passivierschichtöffnung in der Passivierschicht vorliegt.

6. Herstellungsverfahren nach Anspruch 3, **dadurch gekennzeichnet, dass** auf der Funktionsschicht (2) eine Kontaktschicht (6) aufgebracht wird, welche das Halbleitersubstrat (1) an dem Dotierbereich durch die Öffnung (21) hindurch elektrisch kontaktiert.

7. Herstellungsverfahren nach einem der vorangehenden Ansprüche, **dadurch gekennzeichnet, dass** das Halbleitersubstrat (1) an der Halbleiteroberfläche (11) unmittelbar vor dem Bilden der Funktionsschicht (2) im Wesentlichen die gleiche Dotierung aufweist, wie im Volumen des Halbleitersubstrats (1).

8. Herstellungsverfahren nach einem der Ansprüche 1 bis 6, **dadurch gekennzeichnet, dass** vor dem Bilden der Funktionsschicht (2) an der Halbleiteroberfläche (11) Dotierbereiche erzeugt werden, deren Dotierung mittels des Eintreibens des Dotierstoffes aus der Funktionsschicht (2) in das Halbleitersubstrat (1) lokal verstärkt und / oder invertiert wird.

9. Herstellungsverfahren nach einem der vorangehenden Ansprüche, **dadurch gekennzeichnet, dass** das Halbleitersubstrat (1) im Volumen ein p-Typ oder ein n-Typ Halbleiter ist.

10. Herstellungsverfahren nach einem der vorangehenden Ansprüche, **gekennzeichnet durch** die Herstellung einer Halbleitersolarzelle aus dem Halbleitersubstrat (1).

## Claims

1. A production method of a semiconductor device, comprising the following method steps:
- providing a semiconductor substrate (1);
- forming a functional layer (2) on a semiconductor surface (11) of the semiconductor substrate (1); and
- generating at least one doping area (3) at the semiconductor surface (11) by feeding a doping material from the functional layer (2) into the semiconductor substrate (1),
wherein the functional layer (2) is formed in such a way that it passivates upon completion of the semiconductor device the semiconductor surface (11) as a passivation layer, **characterized in that** the functional layer (2) is made of aluminum oxide (AlOₓ), titanium oxide (TiOx), magnesium oxide (MgOx) or zinc oxide (ZnOx) and aluminum, titanium, magnesium or zinc of the compound serves correspondingly as doping material.

2. The production method according to claim 1, **characterized in that** the feeding of the doping material from the functional layer (2) into the semiconductor substrate (1) is carried out by means of an energy input.

3. The production method according to claim 2, **characterized in that** the feeding of the doping material from the functional layer (2) into the semiconductor substrate (1) is carried out by means of a localized energy input.

4. The production method according to claim 3, **characterized in that** the localized energy input is carried out by means of a laser source.

5. The production method according to any one of claims 2 to 4, **characterized in that** by means of the energy input an opening (21) is formed in the functional layer (2), which exists upon completion of the semiconductor device as passivation layer opening in the passivation layer.

6. The production method according to claim 3, **characterized in that** on the functional layer (2) a contact layer (6) is applied, which electrically contacts the semiconductor substrate (1) at the doping area through the opening (21).

7. The production method according to one of the preceding claims, **characterized in that** the semiconductor substrate (1) has on the semiconductor surface (11) immediately before forming the functional layer (2) essentially the same doping as in the volume of the semiconductor substrate (1).

8. The production method according to any one of claims 1 to 6, **characterized in that** before forming the functional layer (2) at the semiconductor surface (11) doping areas are generated, the doping of which is locally amplified and / or inverted by means of the feeding of the doping material from the functional layer (2) into the semiconductor substrate (1).

9. The production method according to one of the preceding claims, **characterized in that** the semiconductor substrate (1) in the volume is a p-type or an n-type semiconductor.

10. The production method according to one of the preceding claims, **characterized by** the production of a semiconductor solar cell from the semiconductor substrate (1).

## Revendications

1. Un procédé de fabrication d'un dispositif semi-conducteur, comprenant les étapes de procédé suivantes :
- fournir un substrat semi-conducteur (1) ;
- former une couche fonctionnelle (2) sur une surface semi-conductrice (11) du substrat semi-conducteur (1) ; et
- générer au moins une zone de dopage (3) à la surface semi-conductrice (11) en enfonçant un matériel dopant de la couche fonctionnelle (2) dans le substrat semi-conducteur (1),
dans lequel la couche fonctionnelle (2) est formée de telle sorte qu'elle passive à l'achèvement du dispositif semi-conducteur la surface semi-conductrice (11) comme couche de passivation, **caractérisé en ce que** la couche fonctionnelle (2) est formée à partir d'oxyde d'aluminium (AlOₓ), oxyde de titane (TiOx), oxyde de magnésium (MgOx) ou oxyde de zinc (ZnOx) et l'aluminium, le titane, le magnésium ou le zinc du composé sert de matériel dopant.

2. Le procédé de fabrication selon la revendication 1, **caractérisé en ce que** l'enfoncement du matériel dopant de la couche fonctionnelle (2) dans le substrat semi-conducteur (1) est effectué au moyen d'un apport énergétique.

3. Le procédé de fabrication selon la revendication 2, **caractérisé en ce que** l'enfoncement du matériel dopant de la couche fonctionnelle (2) dans le substrat semi-conducteur (1) est effectué au moyen d'un apport d'énergie localisé.

4. Le procédé de fabrication selon la revendication 3, **caractérisé en ce que** l'apport d'énergie localisé est effectué au moyen d'une source laser.

5. Le procédé de fabrication selon l'une des revendications 2 à 4, **caractérisée en ce que** par l'apport d'énergie un orifice (21) est formé dans la couche fonctionnelle (2), qui à l'achèvement du dispositif semi-conducteur existe comme orifice de couche de passivation dans la couche de passivation.

6. Le procédé de fabrication selon la revendication 3, **caractérisé en ce que** sur la couche fonctionnelle (2) une couche de contact (6) est appliquée, qui contacte électriquement le substrat semi-conducteur (1) à la zone de dopage par l'orifice (21).

7. Le procédé de fabrication selon l'une des revendications précédentes, **caractérisée en ce que** le substrat semi-conducteur (1) à la surface du semi-conducteur (11) a immédiatement avant la formation de la couche fonctionnelle (2) essentiellement le même dopage comme dans le volume du substrat semi-conducteur (1).

8. Le procédé de fabrication selon l'une des revendications 1 à 6, **caractérisée en ce qu'**avant la formation de la couche fonctionnelle (2) des zones de dopage sont générées à la surface semi-conductrice (11), dont le dopage est localement amplifié et / ou inversé au moyen de l'enfoncement du matériel de dopage de la couche fonctionnelle (2) dans le substrat semi-conducteur (1).

9. Le procédé de fabrication selon l'une des revendications précédentes, **caractérisée en ce que** le substrat semi-conducteur (1) dans le volume est un semi-conducteur de type p ou de type n.

10. Le procédé de fabrication selon l'une des revendications précédentes, **caractérisée par** la fabrication d'une cellule solaire semi-conductrice à partir du substrat semi-conducteur (1).
